Europäisches Patentamt

European Patent Office

Office européen des brevets

(19)

(11) Numéro de publication : **0 284 484 B1**

(12) **FASCICULE DE BREVET EUROPEEN**

(45) Date de publication du fascicule du brevet :
18.12.91 Bulletin 91/51

(51) Int. Cl.⁵ : **H03B 9/14**

(21) Numéro de dépôt : 88400580.2

(22) Date de dépôt : 11.03.88

(54) Oscillateur hyperfréquence intégré dans un guide d'ondes.

(30) Priorité : 17.03.87 FR 8703652

(43) Date de publication de la demande :
28.09.88 Bulletin 88/39

(45) Mention de la délivrance du brevet :
18.12.91 Bulletin 91/51

(84) Etats contractants désignés :
DE GB NL

(56) Documents cités :
EP-A- 0 036 476
EP-A- 0 053 945
EP-A- 0 202 152
IEEE TRANSACTIONS ON ELECTRON DEVICES, vol. ED-17, no. 1, janvier 1970, pages 47-52, New York US; D.L. RODE:
"Dielectric-loaded self-resonant LSA diode"

(73) Titulaire : **THOMSON HYBRIDES ET MICROONDES**
**173, bld Haussmann**
**F-75008 Paris (FR)**

(72) Inventeur : **Stevance, Jean**
**THOMSON-CSF SCPI 19, avenue de Messine**
**F-75008 Paris (FR)**
Inventeur : **Mamodaly, Narguise**
**THOMSON-CSF SCPI 19, avenue de Messine**
**F-75008 Paris (FR)**

(74) Mandataire : **Taboureau, James et al**
**THOMSON-CSF SCPI**
**F-92045 Paris La Défense Cédex 67 (FR)**

Jouve, 18, rue Saint-Denis, 75001 PARIS

## Description

La présente invention concerne un oscillateur hyperfréquence à diode stabilisée par un résonateur diélectrique, cet oscillateur ayant une stabilité améliorée par rapport aux oscillateurs de types connus.

Il fonctionne dans la bande W, de 56 à 100 GHz, et sa conception a été orientée par la nécessité de disposer d'une grande stabilité pour pouvoir fonctionner en émission et en réception alternativement, avec un temps très court de rétablissement de sa fréquence d'oscillation propre après chaque commutation émission-réception.

L'encombrement du spectre des fréquences dans les bandes I et J, respectivement de 8 à 10 GHz et de 10 à 20 GHz, a conduit à rechercher l'emploi de fréquences plus élevées, aux longueurs d'ondes millimétriques, en particulier dans le domaine des télécommunications.

La gamme d'ondes millimétriques présente l'avantage d'avoir une meilleure résolution dans son orientation, et une meilleure pénétration de l'atmosphère et des nuages : le choix de 94 GHz est justifié par l'existence d'une fenêtre de propagation atmosphérique autour de cette fréquence.

Pour pouvoir communiquer au moyen d'ondes hyperfréquences, la conception d'un oscillateur de très bonne stabilité, possédant de bonnes caractéristiques de bruit en modulation d'amplitude, une puissance moyenne, et pouvant assurer à la fois le rôle d'oscillateur local et celui de source d'émission dans un système émetteur-récepteur fonctionnant en bande millimétrique, peut être faite :

    — soit par génération directe,

    — soit par mélange d'un oscillateur millimétrique stable, peu bruyant, et d'un oscillateur commandé en tension à fréquence plus basse.

Les problèmes de passage de l'état d'émission à l'état de réception se trouvent alors transposés à une fréquence plus basse et ils sont donc diminués.

Dans les oscillateurs connus, à diode à résistance négative, stabilisés par résonateur diélectrique, ce dernier joue le rôle d'un court-circuit placé au plus près de la diode ; les performances de l'oscillateur ainsi réalisé sont donc équivalentes à celles d'une cavité résonnante purement métallique de volume plus élevé à laquelle la diode serait magnétiquement couplée, le résonateur correspondant à l'un des murs de la cavité métallique. Le volume de la cavité ainsi engendré est plus petit ce qui explique la diminution de la dérive en fréquence obtenue. Le résonateur diélectrique ne représente pas dans cette structure l'élément résonnant principal ; il semble donc, malgré une optimisation du coefficient de température du matériau du résonateur, difficile d'aboutir avec un tel système à une stabilité de fréquence compatible avec celle requise par les dispositifs émetteurs-récepteurs.

Dans l'oscillateur selon l'invention, le résonateur diélectrique est le seul élément résonant, ce qui assure une plus grande stabilité en fréquence et une plus grande pureté du spectre. La diode est positionnée par rapport au guide de telle sorte que la fréquence d'oscillation corresponde à la fréquence de résonnance propre du résonateur ; ce dernier est placé par rapport à la diode de façon à fournir un couplage diode-résonateur-guide d'onde optimum. Ce couplage est obtenu par une boucle de couplage, constituée par une capacité montée entre le résonateur et le couvercle métallique du boîtier de la diode, et un fil métallique connecté entre l'armature supérieure de la capacité et la masse.

La polarisation de la diode se fait dans le plan du guide, ce qui améliore la compacité du système. L'adaptation de l'oscillateur à la charge utile (optimum de puissance) est réalisée à l'aide d'iris variables et par le positionnement vertical du support de diode, que ce montage permet de faire varier.

Pour une fréquence $f \neq fo$ fréquence propre du résonateur ce dernier se comporte comme un court-circuit et la diode est chargée par la charge annexe. Aucune oscillation n'apparaît.

Pour $f = fo$, le résonateur présente une charge infinie et l'ajustement de sa position par rapport à la diode permet de ramener sur cette dernière l'impédance correcte pour la faire osciller. De cette manière, le résonateur diélectrique est le seul élément résonant qui fixe la fréquence de l'oscillateur.

De façon plus précise l'invention concerne un oscillateur hyperfréquence, intégré dans un guide d'ondes comportant une diode à résistance négative, encapsulée dans un micro-boîtier fermé par un couvercle métallique dit "cap", qui est en contact électrique avec la diode, cet oscillateur étant stabilisé par un résonateur diélectrique et étant caractérisé en ce que le résonateur diélectrique est fixé sur une capacité, elle-même fixée sur le cap du micro-boîtier de la diode, et en ce qu'il comporte en outre une boucle de couplage connectée d'une part à la capacité elle-même connectée au cap de la diode, et d'autre part à la masse, afin d'assurer un bon couplage avec une charge annexe qui limite une cavité dans le guide d'ondes et avec le résonateur diélectrique, qui constitue le seul élément résonant dans l'oscillateur

L'invention sera mieux comprise par la description suivante d'un exemple de réalisation, cette description s'appuyant sur les figures jointes en annexe qui représentent :

    — figure 1 : vue en coupe d'un oscillateur à diode à résistance négative, stabilisée par un résonateur, selon l'art connu,

    — figure 2 : vue en coupe partielle d'un oscillateur à diode à résistance négative, selon l'invention,

    — figure 3 : vue en plan partiel, correspondant à la coupe de la figure 2, d'un oscillateur selon l'invention,

—figure 4 : vue en plan montrant le couplage entre le résonateur et le champ magnétique, dans l'oscillateur selon l'invention,

—figure 5 : schéma électrique de l'oscillateur à diode selon l'invention.

Un oscillateur à diode à résistance négative, de type "Gunn" ou "Impatt", stabilisée par résonateur diélectrique est connu par exemple de la demande de brevet français n° 8507400, déposée le 15 Mai 1985 par la demanderesse et correspondant à la demande EP-A 0202152, publiée le 20/11/1986.

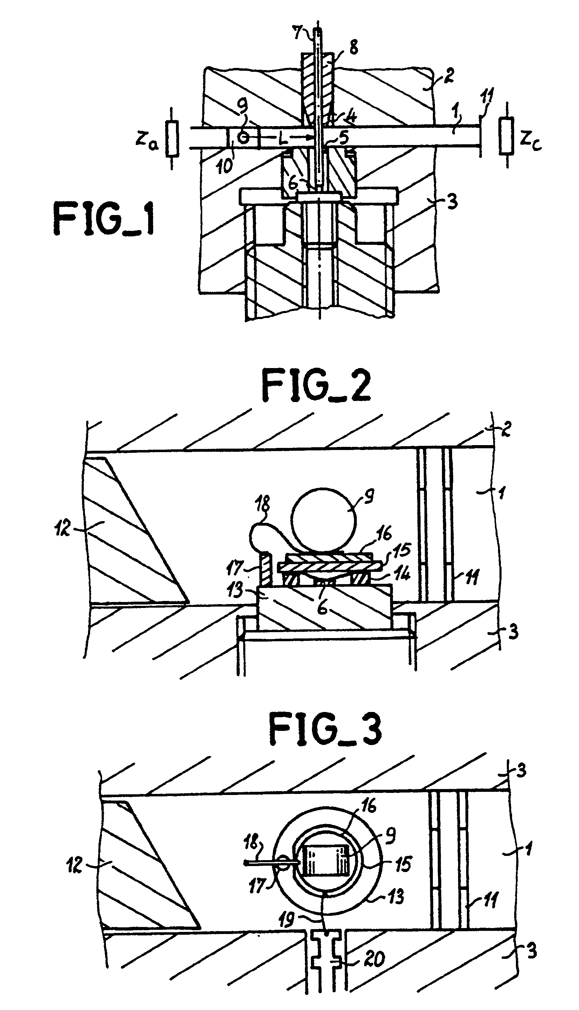

Un tel oscillateur dont la partie active est représentée en figure 1 comporte un guide d'ondes 1 formé par deux rainures dans deux blocs métalliques 2 et 3. Aux fréquences de l'ordre de 94 GHz, ce guide d'ondes a une section de l'ordre de 2,54 mm × 1,27 mm. En travers du guide d'ondes 1, et dans les blocs 2 et 3 le constituant, sont forés deux trous 4 et 5 perpendiculaires au guide d'ondes. Dans le fond du trou 5 est disposée une diode à résistance négative 6 supportée par une embase adequate, et encapsulée dans un micro-boîtier comportant un anneau de quartz et un couvercle, dit "cap", qui est métallique. A travers le trou 4, passe une tige métallique 7 qui, traversant le bloc métallique 2 à travers un bouchon isolant 8, vient établir le contact électrique sur le cap de la diode 6. Cette tige 7 permet d'amener la polarisation sur la diode, et elle joue le rôle d'antenne pour transférer dans le guide d'ondes 1 l'oscillation électrique de la diode 6.

Sur le côté du guide d'ondes 1 se trouve un résonateur diélectrique 9 supporté et centré dans le guide d'ondes au moyen d'une matière 10 qui maintient le résonateur diélectrique centré par rapport au guide d'ondes. A une première extrêmité du guide d'ondes 1 se trouvent un iris 11 qui permet de focaliser l'énergie sur une charge utile Zc, tandis qu'à l'autre extrêmité du guide d'ondes peut se trouver une charge annexe Za.

Dans cette configuration le résonateur diélectrique 9 joue le rôle d'un court-circuit placé au plus près de la diode. Les performances de l'oscillateur ainsi réalisé sont donc équivalentes à celles d'une cavité résonante purement métallique de volume plus élevé à laquelle la diode serait magnétiquement couplée, le résonateur correspondant à l'un des murs de la cavité métallique. Le volume de la cavité ainsi engendré est plus petit, ce qui explique la diminution de la dérive en fréquence constatée avec ce type d'oscillateur. Cependant le résonateur diélectrique 9 ne représente pas dans cette structure le seul élément résonant : le cap du boîtier de la diode 6, qui est couplé par l'intermédiaire du coaxial formé par la tige 7 d'amenée de polarisation et le bloc métallique 3 formant le guide d'ondes, résonnent également. Il y a donc superposition dans la cavité résonante de la résonance propre au résonateur diélectrique 9 et de la résonance propre au cap de la diode 6. Malgré une optimisation du coefficient de température du matériau du résonateur, il est difficile d'aboutir avec un tel système à une stabilité de fréquence compatible avec celle requise par les dispositifs émetteur-récepteur en très haute fréquence.

Néanmoins on peut noter que l'amélioration d'un tel système par rapport à une structure à cap conventionnel est de 15 db sur le bruit en modulation de fréquence, et la dérive de fréquence, mesurée entre 0 degré et 50 degrés vaut 2,2 MHz par degré au lieu de 3,5 MHz par degré pour un oscillateur conventionnel.

L'objet de l'invention est donc d'obtenir une plus grande stabilité pour un oscillateur à diode à résistance négative stabilisée par résonateur diélectrique. Pour atteindre cet objectif, la topologie du circuit est telle que en dehors de la fréquence fo imposée par le résonateur diélectrique, aucune autre oscillation n'est possible dans le circuit.

Le montage réalisé est représenté en figure 2, qui donne une vue en coupe partielle, limitée à la région entourant la diode, de l'oscillateur selon l'invention, tandis que la figure 3 donne une vue en plan de ce même oscillateur, le plan de la figure 3 étant pris à hauteur de la diode, sur la figure 2.

En figure 2, le guide d'ondes est composé d'une cavité 1 obtenue en rainurant deux blocs métalliques 2 et 3. Cette cavité est limitée du côté de la charge active par un iris 11, et de l'autre côté par une charge annexe 12. Dans la cavité, et sur un socle métallique 13 solidaire du bloc métallique 3, est posée une diode 6 encapsulée dans un boîtier constitué en partie par un anneau de quartz 14 qui entoure la diode 6 et par un couvercle ou cap 15 qui referme le boîtier, et dont le diamètre permet de faire une adaptation d'impédance de la diode. La diode, qui est à la masse par une face de sa pastille, est réunie par au moins un fil métallique au cap 15, sur lequel est appliquée la polarisation de diode.

Une caractéristique de l'oscillateur selon l'invention est que le résonateur diélectrique 9 est ramené sur la diode, et non plus à côté de la diode comme cela se faisait auparavant, ce résonateur étant posé sur un condensateur 16, qui est un disque céramique métallisé sur ses deux faces, ce condensateur étant lui-même fixé sur le cap 15. Sur le côté du boîtier de diode, un plot 17 métallique est fixé sur l'embase 13 de la diode : ce plot est donc mis à la masse.

Lorsque la diode, polarisée et convenablement placée dans le guide d'ondes, oscille, la fréquence de fonctionnement fo est celle du résonateur diélectrique 9. Toute fréquence différente de fo est impossible, car dans ce cas le résonateur diélectrique étant équivalent à un court-circuit, ceci a pour conséquence de charger la diode par la charge annexe, ce qui entraîne la non satisfaction des conditions de démarrage de l'oscillateur.

La figure 3 complète la figure 2 en ce sens qu'elle permet de voir comment est polarisée la diode 6. En effet, dans les oscillateurs selon l'art connu, la diode est très généralement polarisée au moyen d'une antenne telle que 7 en figure 1. Mais comme selon l'invention un cylindre de matériau diélectrique 9 est fixé par dessus la diode, et qu'il y a en outre un condensateur 16 par dessus la diode, il n'est pas possible de polariser la diode selon ce principe de l'antenne. Selon l'invention, la polarisation se fait dans le plan du guide par un fil ou un ruban métallique 19, qui est soudé d'une part sur le cap 15 de la diode et d'autre part sur une traversée 20, présentant une suite de régions capacitives et selfiques par métallisation d'un morceau de substrat diélectrique qui passe à travers une cloison 3 du guide d'ondes.

L'adaptation de l'oscillateur à la charge utile, c'est-à-dire son optimum de puissance, est réalisée à l'aide d'iris variables 11, et par le positionnement de la diode dans le guide d'ondes 1. D'une part le support de la diode peut être déplacé verticalement par rapport au guide d'ondes, d'autre part la boucle de couplage 18 peut être déplacée légèrement dans la cavité.

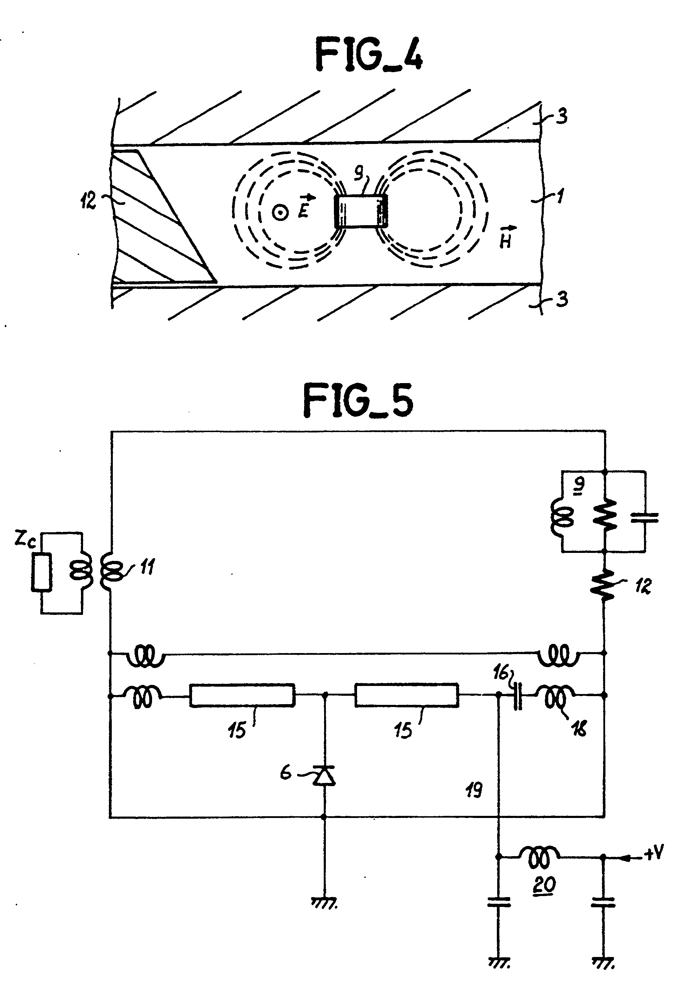

La figure 4 ne représente que les éléments de la cavité et le résonateur 9 nécessaire pour comprendre le positionnement relatif de la diode par rapport à la cavité. A l'intérieur du guide d'ondes 1, le champ électrique $\vec{E}$ est perpendiculaire au plan sur lequel est fixée la diode 6 : ainsi sur la figure 2 le champ électrique est représenté verticalement, dans le plan de la figure, tandis que sur les figures 3 et 4 le champ électrique est perpendiculaire au plan de la figure. Par contre, le champ magnétique $\vec{H}$ présente une série d'oscillations représentées par des régions en pointillés, et l'oscillateur selon l'invention sera à son optimum de puissance si le résonateur diélectrique 9 est correctement couplé à ces régions d'oscillations du champ magnétique H. Ceci peut être obtenu en optimisant la position du résonateur, et de la boucle de couplage 18.

Le schéma équivalent de l'oscillateur selon l'invention est donné en figure 5. La diode 6 est montée dans un boîtier dont la métallisation supérieure appelée "cap" (15) est symbolisée par un tronçon de ligne microbande de longueur approximativement égale à $\lambda/4$, $\lambda$ étant la longueur d'onde de fonctionnement de l'oscillateur. Le cap effectue une transformation d'impédance entre celle vue à sa périphérie et celle relativement faible de la diode à résistance négative, connectée en son centre.

La diode 6 est polarisée, par l'intermédiaire du cap 15, par une tension V + amenée par un fil métallique 19 et par une traversée de cloison 20, qui présente une succession de régions capacitives et selfiques de façon à éviter les pertes hyperfréquence à travers l'orifice pratiqué dans la paroi du guide d'ondes. Cette diode 6 est couplée à un résonateur 9 représenté par un circuit bouchon. En série avec le résonateur, se trouvent la charge annexe 12, couplée magnétiquement, et la charge utile $Z_c$ dont le couplage au circuit est représenté également par un transformateur.

Selon l'invention, une capacité 16 est fixée sur le cap 15, et cette capacité 16 a elle-même son électrode libre d'accès mise à la masse par l'intermédiaire d'un ruban métallique 18 de longueur L qui forme une boucle permettant le couplage de la diode au résonateur diélectrique et à la charge annexe 12.

Plusieurs paramètres contribuent au choix de la diode 6. D'une part l'oscillateur selon l'invention a été étudié pour s'insérer dans une chaîne comprenant un mélangeur et un oscillateur commandé en tension à fréquence plus basse. Par exemple, l'oscillateur de l'invention oscille à 85 GHz, et un oscillateur commandé en tension oscille à 9 GHz : en additionnant les deux fréquences, la fréquence générée est de 94 GHz, et elle doit être compatible avec le niveau requis par le transposeur, qui en agissant sur la fréquence de l'oscillateur commandé en tension permet de passer de l'émission à la réception. La caractéristique de bruit de modulation d'amplitude compte tenu de la commutation entre l'émission et la réception, c'est-à-dire une variation de fréquence de l'ordre de 128 MHz, compte pour le choix de la diode qui peut être de l'un des deux types suivants :

— diode "Gunn InP", avec des puissances obtenues couramment dans la gamme de fréquence considérée de l'ordre de 50 mW,

— diode à avalanche Si.

Les diodes Impatt commercialisées donnent des puissances supérieurs à 200 mW en bande W, entre 56 et 100 GHz. La puissance de l'oscillateur avec de tels composants est donc supérieure aux 20 mW nécessaires au transposeur, cependant les diodes à avalanche sont plus bruiteuses que les diodes Gunn. Or, il est démontré qu'une diode Impatt utilisée en-deçà de 80% de sa puissance maximale présente un bruit plus faible en modulation de fréquence. De la même façon le bruit en modulation d'amplitude peut être réduit : par conséquent les diodes à avalanche en silicium sont intéressantes puisque on sait réduire le bruit en modulation d'amplitude et le bruit en modulation de fréquence.

L'oscillateur selon l'invention a donné, pour une fréquence de fonctionnement de 85 GHz et une puissance supérieure ou égale à 20 mW, une stabilité de:

± 1 MHz pendant un temps inférieur à 10,4 ms après la commutation

± 25 MHz pendant un temps supérieur à 10,4 ms après la commutation, et

± 10 MHz en fonctionnement entre –20°C et +60°C.

Il est utilisé pour la réalisation de matériels hyperfréquence fonctionnant en émission et en réception dans le domaine des hyperfréquences, mais plus particulièrement dans la fenêtre de 94 GHz qui correspond à une limpidité de l'atmosphère pour les transmissions aériennes, en émission et en réception. Il est précisé par les revendications suivantes.

## Revendications

1. Oscillateur hyperfréquence, intégré dans un guide d'ondes (1) comportant une diode (6) à résistance négative, encapsulée dans un micro-boîtier (14) fermé par un couvercle métallique dit "cap" (15), qui est en contact électrique avec la diode (6), cet oscillateur étant stabilisé par un résonateur diélectrique (9) et étant caractérisé en ce que le résonateur diélectrique (9) est fixé sur un condensateur (16), lui-même fixé sur le cap (15) du micro-boîtier de la diode (6), et en ce qu'il comporte en outre une boucle de couplage (18) connectée d'une part au condensateur (16), lui-même connecté au cap (15) de la diode (6), et d'autre part à la masse, afin d'assurer un bon couplage avec une charge annexe (12) qui limite une cavité dans le guide d'ondes et avec le résonateur diélectrique (9), qui constitue le seul élément résonant dans l'oscillateur.

2. Oscillateur hyperfréquence selon la revendication 1, caractérisé en ce qu'il comprend, fixé dans une paroi (3) du guide d'ondes (1) :
— une embase métallique (13) à la masse,
— une diode (6) à résistance négative, fixée sur l'embase (13) et encapsulée par un anneau de diélectrique (14) et un cap (15), soudé sur l'anneau, et en contact électrique avec la diode (6),
— un condensateur (16) fixé sur le cap (15), par une première électrode,
— un résonateur diélectrique (9) fixé sur le condensateur (16),
— un ruban métallique (18), soudé par une extrêmité sur une seconde électrode du condensateur (16), et par l'autre extrêmité sur un plot (17) métallique, lui-même à la masse par l'intermédiaire de l'embase (13) de la diode (6).

3. Oscillateur hyperfréquence selon la revendication 2, caractérisé en ce que la longueur du ruban métallique (18) et la valeur du condensateur (16) sont choisies pour assurer un bon couplage diode (6), charge annexe (12) et résonateur diélectrique (9).

4. Oscillateur hyperfréquence selon l'une quelconque des revendications 1 à 3, caractérisé en ce que l'oscillateur est optimisé par rapport à la cavité du guide d'ondes (1) par :
— déplacement de l'ensemble diode - résonateur (6, 9) selon un axe orthogonal au guide d'ondes (1),
— déplacement de la boucle de couplage (18).

5. Oscillateur hyperfréquence selon la revendication 2, caractérisé en ce que la diode (6) est polarisée par une tension au moyen d'un fil métallique (19), soudé à une extrêmité sur le cap (15) de la diode (6), et à une autre extrêmité sur un circuit (20) métallique, gravé sur une plaquette de diélectrique, qui traverse une paroi (3) du guide d'ondes (1).

## Patentansprüche

1. Ultrahochfrequenz-Oszillator, der in einen Wellenleiter (1) integriert ist, der eine Diode (6) mit Negativwiderstand aufweist, die in einem Mikrobehälter (14) eingekapselt ist, der von einem mit "Cap" bezeichneten metallischen Deckel (15) verschlossen wird, der mit der Diode (6) in elektrischem Kontakt ist, wobei der Oszillator von einem dielektrischen Resonator (9) stabilisiert wird und dadurch gekennzeichnet ist, daß der dielektrische Resonator (9) auf einem Kondensator (16) befestigt ist, der selbst auf dem Deckel (15) des Mikrobehälters der Diode (6) befestigt ist, und daß er außerdem eine Koppelschleife (18) aufweist, die einerseits mit dem Kondensator (16), der selbst mit dem Deckel (15) der Diode (6) verbunden ist, und andererseits mit Masse verbunden ist, um mit einem angefügten Abschluß (12), der im Wellenleiter einen Hohlraum begrenzt, und mit dem dielektrischen Resonator (9), der im Oszillator das einzige Resonanzelement bildet, eine gute Kopplung sicherzustellen.

2. Ultrahochfrequenz-Oszillator gemäß Anspruch 1, dadurch gekennzeichnet, daß er, befestigt an einer Wand (3) des Wellenleiters (1), umfaßt :
— eine metallische Befestigungsfläche (13) auf Masse,
— eine Diode (6) mit Negativwiderstand, die auf der Befestigungsfläche (13) befestigt ist und mittels eines dielektrischen Rings (14) und eines Deckels (15) eingekapselt ist, am Ring verlötet ist und mit der Diode (6) in elektrischem Kontakt ist,
— einen Kondensator (16), der am Deckel (15) mittels einer ersten Elektrode befestigt ist,
— einen dielektrischen Resonator (9), der am Kondensator (16) befestigt ist,
— ein Metallband (18), das mit einem Ende an einer zweiten Elektrode des Kondensators (16) und mit dem anderen Ende mit einem metallischen Anschlußkontakt (17) verlötet ist, wobei der Anschlußkontakt (17) selbst über die Befestigungsfläche (13) der Diode (6) mit Masse verlötet ist.

3. Ultrahochfrequenz-Oszillator gemäß Anspruch 2, dadurch gekennzeichnet, daß die Länge des Metallbandes (18) und der Wert des Kondensators (16) so gewählt werden, daß zwischen der Diode (6), dem angefügten Abschluß (12) und dem dielektrischen Resonator (9) eine gute Kopplung sichergestellt ist.

4. Ultrahochfrequenz-Oszillator gemäß einem der Ansprüche 1 bis 3, dadurch gekennzeichnet, daß der Oszillator in bezug auf den Hohlraum des Wellenleiters (1) optimiert wird durch :

— die Verschiebung der Einheit Diode/Resonator (6, 9) entlang einer zum Wellenleiter (1) senkrechten Achse,

— die Verschiebung der Koppelschleife (18).

5. Ultrahochfrequenz-Oszillator gemäß Anspruch 2, dadurch gekennzeichnet, daß die Diode (6) mittels eines Metalldrahtes (19) durch eine Spannung vorgespannt wird, wobei der Metalldraht (19) mit einem Ende mit dem Deckel (15) der Diode (6) und mit dem anderen Ende mit einer metallischen Leitung (20), die in ein eine Wand (3) des Wellenleiters (1) durchsetzendes dielektrisches Plättchen eingraviert ist, verlötet ist.

## Claims

1. A microwave oscillator, integrated in a wave guide (1) comprising a negative resistance diode (6) which is encapsulated in a micro-enclosure (14) sealed off by a metallic cover in the form of a cap (15) which is in electrical contact with the diode (6), said oscillator being stabilized by a dielectric resonator (9) and being characterized in that the dielectric resonator (9) is fixed on a capacitor (16), which is itself fixed on the cap (15) of the micro-enclosure of the diode (6) and in that it comprises furthermore a coupling loop (18) connected on the one hand with the capacitor (16), which is itself connected with the cap (15) of the diode (6), and on the other hand with ground in order to ensure satisfactory coupling with an adjacent load (12) which limits a cavity in the wave guide and with the dielectric resonator (9), which constitutes the sole resonant element in the oscillator

2. The microwave oscillator as claimed in claim 1, characterized in that it comprises, secured in a wall (3) of the wave guide (1) :

— a metallic seat (13) connected with ground,

— a negative resistance diode (6), fixed to the seat (13) and encapsulated by means of a dielectric ring (14) and a cap (15) soldered on the ring and in electrical contact with the diode (6),

— a capacitor (16) fixed on the cap (15) by a first electrode,

— a dielectric resonator (9) fixed on the capacitor (16),

— a piece of metallic ribbon (18), soldered at one end on a second electrode of the capacitor (16) and at the other end on a metallic stud (17), which itself is connected with ground by means of the seat (13) of the diode (6).

3. The microwave oscillator as claimed in claim 2, characterized in that the length of the metallic ribbon (18) and the capacitance of the capacitor (16) are selected in order to ensure a satisfactory coupling between the diode (6), the adjacent load (12) and the dielectric resonator (9).

4. The microwave oscillator as claimed in any one of the preceding claims 1 through 3, characterized in that the oscillator is optimized in relation to the cavity of the wave guide (1) by :

— displacement of the diode-resonator unit (6 and 9) along an axis at a right angle to the wave guide (1), and

— displacement of the coupling loop (18).

5. The microwave oscillator as claimed in claim 2, characterized in that the diode (6) is biased by a voltage using a metallic wire (19), soldered at one end to the cap (15) of the diode (6), and at the other end to a metallic circuit (20), engraved on a dielectric plate, which extends through a wall (3) of the wave guide (1).

FIG_1

FIG_2

FIG_3

# FIG_4

# FIG_5